# EUROPEAN PATENT APPLICATION

(11) **EP 1 049 159 A2**
(43) Date of publication of application: **02.11.2000**
(21) Application number: 00303351.1
(22) Date of filing: 20.04.2000
(51) Int. Cl.: H01L 21/8234

(54) **A method of forming dual thickness gate oxide in a semiconductor device**

(30) Priority: 28.04.1999 US 301397
(71) Applicant: LUCENT TECHNOLOGIES INC., Murray Hill, New Jersey 07974-0636 (US)
(72) Inventor: Kizilyalli, Isik C., Winterpark, Florida 32789 (US); Ma, yi, Orlando, Florida 32837 (US); Radosevich, Joseph R., Orlando, Florida 32819 (US); Roy, Pradip K., Orlando, Florida 32819 (US)
(74) Representative: Watts, Christopher Malcolm Kelway, Dr.

(57) **Abstract**

The present invention is directed to a method of forming a multi-thickness gate oxide in a gate-dielectric stack structure. The invention is particularly well-suited for sub-micron CMOS technology devices and circuits, but is not limited thereto. The present invention is also directed to semiconductor devices having a dual-thickness gate oxide. The present invention advantageously permits formation or growth of a gate oxide to a first thickness and, thereafter, formation or growth of the gate oxide to a second thickness. The step of forming or growing the gate oxide to the second thickness is performed without affecting the first thickness. Thus, the present invention provides complete and independent control over the thickness of each of the gate oxides, which may be formed or grown at different temperatures or under different conditions.

## Description

### Field Of The Invention

The present invention relates to integrated circuits and, more particularly, to a method of forming dual thickness gate oxide in a semiconductor device.

### Background Of The Invention

Sub-micron CMOS integrated circuits typically include semiconductor devices (transistors, for example) that operate at different supply voltages, e.g., 1.5 VDC and 3.3 VDC. The different supply voltages require different thickness dielectrics or gate oxides, with the higher voltage device requiring a thicker gate oxide.

One method for providing a dual-thickness gate oxide in a sub-micron CMOS integrated circuit requires growing a gate oxide (SiO₂, for example) on a silicon substrate to a predetermined thickness which is not necessarily either of the desired final gate oxide thicknesses. The gate oxide is then selectively removed (etched to expose the silicon substrate) from the area of the low voltage device(s). The gate oxide is then grown a second time, i.e., a new gate oxide is grown over the exposed silicon and the gate oxide not etched is grown to a greater thickness. The gate oxide remaining after the selective removal grows thicker and forms the thicker gate oxide. A new gate oxide grows in the area where it was previously removed and forms the thinner gate oxide. Both the thin and thick gate oxides are simultaneously grown to their desired final thickness. This method makes it difficult to control the finished thickness of either of the gate oxides independently. In addition, this process is generally considered a "dirty" process because cleaning is required after the gate oxide is removed or etched away.

Another method requires growing the gate oxide to its desired thickness for the thicker gate oxide. The gate oxide is then masked over the high-voltage devices, and the oxide is etched back to the desired thickness of the thinner gate oxide over the low-voltage devices. This method provides very little control over the thickness of the thinner gate oxide and is also a generally "dirty" manufacturing process.

Yet another method requires implanting Nitrogen into a previously grown gate oxide in the area over the low voltage devices, i.e., the thinner gate oxide. The Nitrogen will retard subsequent oxidation of these areas. Thus, when a second oxide growth is performed to grown the thicker gate oxide, the Nitrogen-implanted areas will not increase in thickness to any significant degree. Unfortunately, introduction of Nitrogen into the gate oxide over the low voltage devices degrades the hole mobility in these areas. In addition, this process is limited to relatively small differences between the desired thick and thin gate oxide thicknesses.

There thus exists a need in the art for a method of forming dual thickness gate oxide in a semiconductor device.

### Summary Of The Invention

The present invention is directed to a method of forming a multi-thickness gate oxide in a gate-dielectric stack structure. The invention is particularly well-suited for sub-micron CMOS technology devices and circuits, but is not limited thereto. The present invention is also directed to semiconductor devices having a dual-thickness gate oxide. The present invention advantageously permits formation or growth of a gate oxide to a first thickness and, thereafter, formation or growth of selective parts of the same gate oxide to a second thickness. The step of forming or growing the gate oxide to the second thickness is performed without affecting the first thickness. Thus, the present invention provides complete and independent control over the thickness of each of the gate oxides, which may be formed or grown at different temperatures or under different conditions.

In a first embodiment, the present invention is directed to a method of forming a multi-thickness gate oxide in a gate-dielectric stack structure including a silicon substrate and having a first device defined therein and operable at a first voltage, and having a second device defined therein and operable at a second voltage that is different from the first voltage. The method comprises forming a gate oxide to a first thickness on the silicon substrate above the first device and the second device. An oxygen diffusion barrier is then deposited over the gate oxide and a mask is applied over the oxygen diffusion barrier. The mask is selectively applied above only one of the first and second devices. By etching or other known methods and techniques, the oxygen diffusion barrier and gate oxide are removed from the gate-dielectric stack structure above the device over which the mask is not applied. The gate oxide is then formed to a second thickness on the silicon substrate above the device over which the mask is not applied. The gate oxide second thickness is different from the gate oxide first thickness and the oxygen diffusion barrier preventing changes in the gate oxide first thickness.

The present invention is also directed to a semiconductor device comprising a gate-dielectric stack structure including a silicon substrate and having a first device defined therein and operable at a first voltage, and having a second device defined therein and operable at a second voltage that is different from the first voltage. The semiconductor device includes a gate oxide located above the first and said second devices and having a first thickness above the first device and a second thickness above the second device. The second gate oxide thickness is different from first gate oxide thickness, and the second gate oxide thickness is formed independent of the first gate oxide thickness. The semiconductor device also includes an oxygen diffusion barrier located above the first gate oxide layer with first thickness and preventing oxidation of the first gate oxide layer during formation of the second gate oxide thickness.

Other objects and features of the present invention will become apparent from the following detailed description, considered in conjunction with the accompanying drawing figures. It is to be understood, however, that the drawings, which are not to scale, are designed solely for the purpose of illustration and not as a definition of the limits of the invention, for which reference should be made to the appended claims.

### Brief Description Of The Drawings

In the drawing figures, which are not to scale, and which are merely illustrative, and wherein like reference characters denote similar elements throughout the several views:
FIG. 1 depicts a gate-dielectric stack structure having a gate oxide of substantially uniform thickness and a silicon-nitride oxygen diffusion barrier above a first and a second device defined in the gate-dielectric stack structure;
FIG. 2 depicts the gate-dielectric stack structure of FIG. 1 having a mask located above one of the first and second devices;
FIG. 3 depicts the gate-dielectric stack structure of FIG. 2 having the silicon-nitride oxygen diffusion barrier and gate oxide removed from the structure over one of the first and second devices; and
FIG. 4 depicts a gate-dielectric stack structure having a dual-thickness gate oxide and constructed in accordance with the present invention.

### Detailed Description Of The Presently Preferred Embodiments

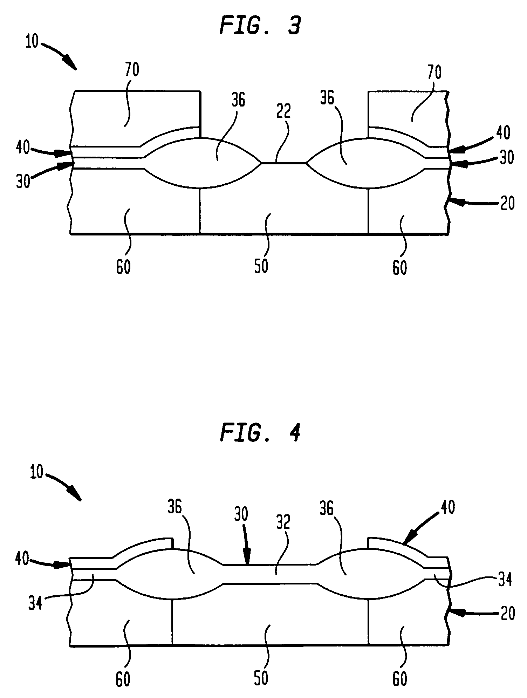

Referring now to the drawings in detail, and with reference first to FIG. 4, a gate-dielectric stack structure 10 including a silicon substrate 20 having a first device 50 and a second device 60 defined therein is there depicted. The first device 50 is operable at a first voltage and the second device 60 is operable at a second voltage that is different from the first voltage. In the illustrative, non-limiting structure depicted in FIG. 4, the first voltage is greater than the second voltage. Alternatively, the second voltage may be greater than the first voltage. The gate-dielectric stack structure 10 includes a gate oxide or dielectric 30 having a first thickness 32 and a second thickness 34. In the embodiment depicted in FIG. 4, the first thickness 32 is greater than the second thickness 34, although the present invention is applicable to the alternative case. The terms gate oxide and dielectric are used interchangeably herein.

The present invention is generally directed to any gate-dielectric stack structure 10 requiring a dual-thickness gate oxide or dielectric 30, regardless of structure's ultimate application or use. The present invention is particularly, although not exclusively, useful for constructing sub-micron CMOS devices. By way of non-limiting example, the first or second device 50, 60 may be a CMOS integrated circuit such as a microprocessor, digital signal processor, memory device, analog circuit, or application specific integrated circuit (ASIC). The first and second device 50, 60 may alternatively be a MOSFET circuit having devices operable at different voltages. Either of the devices 50, 60 may also be circuits for interfacing, communicating, interconnecting, etc. to another circuit, device, system, etc. external to the gate-dielectric stack structure 10. Such devices would typically be operable at higher voltages than devices within the gate-dielectric stack structure 10 that do not communicate outside of the structure 10.

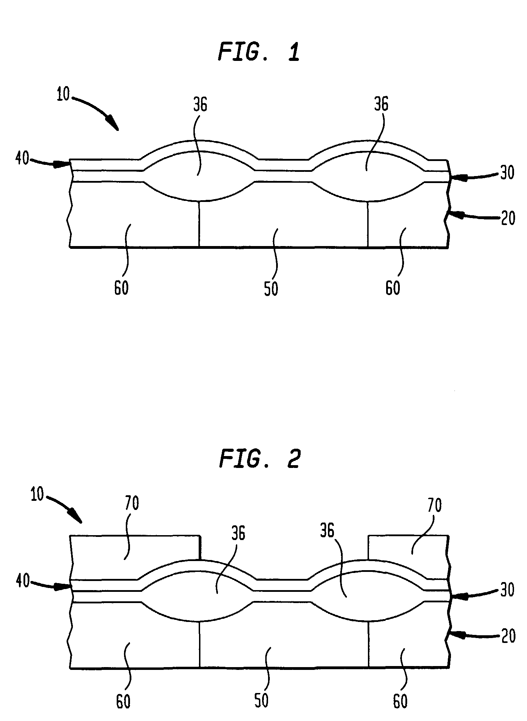

Referring next to FIG. 1, the gate oxide 30 is initially grown to a substantially uniform thickness except for the field oxide regions 36. The gate oxide 30 is preferably silicon-dioxide (SiO₂) and is formed on the silicon substrate 20 to a first desired thickness, as depicted in FIG. 1, using known methods and techniques (e.g., grown by oxidation). The first desired thickness of the gate oxide 30 will depend in part on the gate oxide reliability and the type of device formed in the silicon substrate 20. For example, the gate oxide 30 may be grown to a thickness of 30Å and the field oxide regions 36 may be grown to a thickness of 2000Å. The first device 50 and second device 60 may comprise n-well or p-well devices, as a matter of design choice, and may be formed in the silicon substrate 20 before the gate oxide 30 is formed.

An oxygen diffusion barrier 40 is deposited in blanket fashion over the entire surface of the gate oxide 30. In a preferred embodiment, the barrier comprises silicon-nitride (Si₃N₄). As discussed in more detail below, the barrier 40 prevents further oxidation (i.e., growth) of the gate oxide 30, prevents Boron penetration through the gate oxide. Region 70 is a photoresist mask.

The following description is directed to a specific application of the method of devices constructed in accordance with the present invention, namely forming the thin gate oxide prior to forming the thick gate oxide. However, such description is not intended to limit or otherwise define the present invention, which is equally applicable to methods and devices in which the thick gate oxide is formed prior to the thin gate oxide.

Once the gate oxide 30 is formed to a predetermined first thickness on the silicon substrate 20 and the oxygen diffusion barrier 40 has been deposited over the gate oxide 30, a photoresist mask 70 is selectively patterned over the barrier 40 by methods well known in integrated circuit fabrication technology (photolithography) and only above the devices that require a gate oxide thickness different from the gate oxide thickness already formed on the silicon substrate 20. In the drawings and for purposes of this discussion, the mask 70 is patterned over the second devices 60, which are low voltage devices. The barrier 40 and gate oxide 30 may then be removed from above the first device 50 (a high voltage device) such as by etching, for example, so that a surface 22 of the silicon substrate 20 is exposed (FIG. 3). The photoresist 70 may then be removed and the gate-dielectric stack gate-dielectric stack structure 10 exposed to thermal oxidation to form a new gate oxide 30 above the first device 50. This gate oxide 30 may be selectively grown to a predetermined second thickness that may be thicker or thinner than the predetermined first thickness. The oxygen diffusion barrier 40 deposited over the gate oxide 30 of the first devices 60 prevents further oxidation (i.e., growth) of this gate oxide 30 and thus fixes the thickness of this gate oxide at the thickness to which the gate oxide was originally grown.

For the embodiment depicted in FIG. 4, the first thickness 32 may be in the range of between 30Å and 150Å, and the second thickness may be in the range of between 10Å and 50Å. As noted above, the thickness of the field oxide region 36 is approximately 2000Å, and subsequent growth of a gate oxide as described herein will tend to also grow the silicon-dioxide of the field oxide region 36, but not to any significant amount.

The gate oxide 30 grown over the first device 50 (or alternatively over the second device 60) becomes part of a single gate oxide 30 generally having a first thickness 32, a second thickness 34 and a field oxide region 36. For the embodiment depicted in the drawings, the predetermined second thickness is thicker than the predetermined first thickness. However, the present invention is directed to the alternative instance where the predetermined second thickness is thinner than the predetermined first thickness.

Thus, while there have been shown and described and pointed out fundamental novel features of the invention as applied to preferred embodiments thereof, it will be understood that various omissions and substitutions and changes in the form and details of the disclosed invention may be made by those skilled in the art without departing from the spirit of the invention. It is the intention, therefore, to be limited only as indicated by the scope of the claims appended hereto.

## Claims

1. A method of forming a multi-thickness gate oxide in a gate-dielectric stack structure including a silicon substrate having a first device defined therein and operable at a first voltage, and having a second device defined therein and operable at a second voltage that is different from the first voltage, said method comprising the steps of:
(a) forming a gate oxide to a first thickness on the silicon substrate above the first device and second device;
(b) depositing an oxygen diffusion barrier over the gate oxide formed in said step (a);
(c) patterning a mask over the oxygen diffusion barrier deposited in said step (b), the mask being applied above one of the first and second devices;
(d) removing the oxygen diffusion barrier and gate oxide from the other one of the first and second devices over which the mask is not patterned; and
(e) forming the gate oxide to a second thickness on the silicon substrate above the other one of the first and second devices over which the mask is not applied, the gate oxide second thickness being different from the gate oxide first thickness and the oxygen diffusion barrier preventing changes in the gate oxide first thickness during formation of the gate oxide second thickness.

2. The method of claim 1, wherein the gate oxide first thickness is greater than the gate oxide second thickness.

3. The method of claim 1, wherein the gate oxide second thickness is greater than the gate oxide first thickness.

4. The method of claim 1, wherein said step (b) comprises depositing silicon-nitride over the gate oxide formed in said step (a).

5. The method of claim 1, wherein said step (c) comprises applying a mask over the oxygen diffusion barrier above the first device, and wherein the gate oxide second thickness is greater than the gate oxide first thickness and the second voltage is greater than the first voltage.

6. The method of claim 1, wherein said step (c) comprises applying a mask over the oxygen diffusion barrier above the first device, and wherein the gate oxide first thickness is greater than the gate oxide second thickness and the first voltage is greater than the second voltage.

7. The method of claim 1, wherein said step (c) comprises applying a mask over the oxygen diffusion barrier above the second device, and wherein the gate oxide second thickness is greater than the gate oxide first thickness and the second voltage is greater than the first voltage.

8. The method of claim 1, wherein said step (c) comprises applying a mask over the oxygen diffusion barrier above the second device, and wherein the gate oxide first thickness is greater than the gate oxide second thickness and the first voltage is greater than the second voltage.

9. The method of claim 1, wherein said step (d) comprises removing the oxygen diffusion barrier and gate oxide from the other one of the first and second devices so as to expose the silicon substrate disposed therebeneath.

10. A semiconductor device comprising:
a gate-dielectric stack structure including a silicon substrate having a first device defined therein and operable at a first voltage, and having a second device defined therein and operable at a second voltage that is different from the first voltage;
a gate oxide located above said first and said second devices, said gate oxide having a first thickness above said first device and a second thickness above said second device, said second gate oxide thickness being different from said first thickness, said second gate oxide thickness being formed independent of said first gate oxide thickness; and
an oxygen diffusion barrier located above said gate oxide above one of said first and said second devices, said oxygen diffusion barrier preventing changes in the thickness of said one of said gate oxide thicknesses above said one of said first and said second devices during formation of said other one of said gate oxide thickness.

11. The semiconductor device of claim 10, wherein said first gate oxide thickness is greater than said second gate oxide thickness and wherein said first voltage is greater than said second voltage.

12. The semiconductor device of claim 10, wherein said second gate oxide thickness is greater than said first gate oxide thickness and wherein said second voltage is greater than said first voltage.

13. The semiconductor device of claim 10, wherein said oxygen diffusion barrier is silicon-nitride.

14. The semiconductor device of claim 10, wherein said gate-dielectric stack structure is a CMOS integrated circuit.

15. The semiconductor device of claim 14, wherein said CMOS integrated circuit is a memory device, a microprocessor, an ASIC or a DSP.
